(19) **Europäisches Patentamt**

**European Patent Office**

**Office européen des brevets**

(11) **EP 0 762 489 B1**

(12) **EUROPÄISCHE PATENTSCHRIFT**

(45) Veröffentlichungstag und Bekanntmachung des Hinweises auf die Patenterteilung:
**27.06.2001  Patentblatt 2001/26**

(51) Int Cl.$^7$: **H01L 21/331**, H01L 29/737

(21) Anmeldenummer: **96113670.2**

(22) Anmeldetag: **27.08.1996**

(54) **Verfahren zur Herstellung eines Heterobipolartransistors**

Method for fabricating a heterojunction bipolar transistor

Procédé de fabrication pour un transistor bipolaire à hétérojonction

(84) Benannte Vertragsstaaten:
**DE FR GB**

(30) Priorität: **12.09.1995  DE 19533677**

(43) Veröffentlichungstag der Anmeldung:
**12.03.1997  Patentblatt 1997/11**

(73) Patentinhaber: **DaimlerChrysler AG**
**70567 Stuttgart (DE)**

(72) Erfinder:
- **Brugger, Hans, Dr.**
  **89250 Senden (DE)**
- **Müssig, Harald**
  **89077 Ulm (DE)**

(74) Vertreter: **Fröhling, Werner Otto, Dr. et al**
**DaimlerChrysler AG,**
**Intellectual Property Management,**
**Sedanstr. 10/Gebäude 17**
**89077 Ulm (DE)**

(56) Entgegenhaltungen:
**EP-A- 0 214 802          EP-A- 0 460 285**

- **PROCEEDINGS OF THE INTERNATIONAL CONFERENCE ON INDIUM PHOSPHIDE AND RELATED MATERIALS, HOKKAIDO, MAY 9 - 13, 1995, Nr. CONF. 7, 9.Mai 1995, INSTITUTE OF ELECTRICAL AND ELECTRONICS ENGINEERS, Seiten 652-655, XP000630693 SHOJI YAMAHATA ET AL: "INP/INGAAS COLLECTOR-UP HETEROJUNCTION BIPOLAR TRANSISTORS FABRICATED USING FE-ION-IMPLANTATION"**

- **IEICE TRANSACTIONS ON ELECTRONICS, Bd. E77-C, Nr. 9, 1.September 1994, Seiten 1437-1442, XP000474255 SHOJI YAMAHATA ET AL: "HIGH-PERFORMANCE SMALL-SCALE COLLECTOR-UP ALGAAS GAAS HBT'S WITH A CARBON-DOPED BASE FABRICATED USING OXYGEN-ION IMPLANTATION"**
- **IEEE ELECTRON DEVICE LETTERS, Bd. EDL-07, Nr. 1, Januar 1986, Seiten 32-34, XP000605307 ADACHI S ET AL: "COLLECTOR-UP HBT'S FABRICATED BY BE + AND O + ION IMPLANTATIONS"**
- **JAPANESE JOURNAL OF APPLIED PHYSICS, Bd. 34, Nr. 2B, PART 01, Februar 1995, Seiten 1204-1207, XP000599436 SHIRAKASHI J ET AL: "INGAP/GAAS HETEROJUNCTION BIPOLAR TRANSISTORS WITH AN ULTRA-HIGH CARBON-DOPED BASE (P=1.5 X 10 21 CM -3)"**
- **JAPANESE JOURNAL OF APPLIED PHYSICS, Bd. 30, Nr. 10B, 15.Oktober 1991, Seiten L1787-L1789, XP000235824 TAKASHI HIROSE ET AL: "A SMALL COLLECTOR-UP AIGAAS/GAAS HETEROJUNCTION BIPOLAR TRANSISTOR FABRICATED USING H+ IMPLANTATION"**

**Beschreibung**

Die Erfindung betrifft ein Verfahren zur Herstellung eines Heterobipolartransistors nach dem Oberbegriff des Patentanspruchs 1.

Heterobipolartransistoren (HBTs) werden für schnelle, digitale Anwendungen und für analoge Anwendungen im Bereich der Mikrowellen- und Millimeterwellenfrequenzen als Bauelemente für Leistungsverstärker und Oszillatoren mit geringem Phasenrauschen verwendet.

Bedingt durch die Heterostrukturanordnung, derart, daß ein elektronenleitender (n) Emitterbereich (E) mit größerer, energetischer Bandlücke kombiniert ist mit einem löcherleitenden (p) Basisbereich (B) mit kleinerer, elektronischer Bandlücke, wird die Minoritätsträgerinjektion von der Basis in den Emitter signifikant reduziert und somit der Emitterwirkungsgrad deutlich erhöht. Dies führt zu einer höheren Stromverstärkung. Die maximale Frequenz für Stromverstärkung (Transitfrequenz $f_T$) ist im wesentlichen durch intrinsische Ladungsträgerlaufzeiteffekte und durch kapazitive Ladezeiten limitiert.

Für analoge Schaltungsanwendungen zur Leistungserzeugung bei hohen Frequenzen ist die Kenngröße die maximale Schwingfrequenz ($f_{max}$), die näherungsweise nach folgender Beziehung mit der Transitfrequenz verknüpft ist:

$$f_{max} \cong (f_T/8\pi R_B C_{BC})^{1/2} \qquad (1)$$

mit $R_B$ als Basiswiderstand und $C_{BC}$ als Basis-Kollektorkapazität. $C_{BC}$ und RB sind im wesentlichen von den extrinsischen Bereichen außerhalb des Bauelements bestimmt. Entscheidend für eine hohe Leistungsverstärkung bei der jeweiligen Arbeitsfrequenz ist ein möglichst hohes $f_{max}$. Deshalb kommt entsprechend der Beziehung (1) der Minimierung von $C_{BC}$ und RB eine ganz wesentliche Bedeutung zu.

Bedingt durch die einfachere Technologie werden HBTs gegenwärtig in einer sog. npn E-up/C-down Konfiguration realisiert. Dabei ist das Bauelement als Doppelmesastruktur ausgebildet. Die n-leitende Emitterkontaktschicht liegt auf der oberen Mesa, die p-leitende Basiskontaktschicht liegt auf mittlerer Höhe und die n-leitende Kollektorkontaktschicht bildet die unterste Elektrode. In dieser Konfiguration ist jedoch die extrinsische Basis-Kollektor-Kapazität ($C_{BC}$) durch die hohe dielektrische Konstante des Halbleitermaterials groß.

HBTs mit vorteilhaft niedrigem $C_{BC}$ lassen sich durch eine invertierte Doppelmesa-Anordnung mit obenauf liegendem Kollektorkontakt realisieren, sog. C-up/E-down HBT-Struktur. Allerdings führt dies zu dem Problem der parasitären Strominjektion vom Emitter- in den extrinsischen Basisbereich. Um dies zu verhindern, kann entweder ein sperrender pn-Bereich oder eine elektrisch isolierende Zone im extrinsischem Basis-Emitterbereich eingebaut werden. Ein weiterer Vorteil der C-up Konfiguration ist die Vermeidung von offenen pn-Übergängen am Basis-Emitterbereich. Dies reduziert nachteilige Oberflächenleckströme und -rekombinationsprozesse.

Verfahren zur Reduzierung der Basis-Kollektor-Kapazität ($C_{BC}$) und zur Realisierung von C-up/E-down Strukturen sind bereits bekannt:

a) P.M. Asbeck, D.L. Miller, R.J. Anderson, and F.H. Eisen:
"GaAs/(Ga,Al) As Heterojunction Bipolar Transistors with Buried Oxygen-Implanted Isolations Layers", IEEE Electron Letters (1984), EDL-5, No. 8, pp. 310-312

b) S. Adachi and T. Ishibashi:

Collector-Up HBTs Fabricated by Be[+] and O[+] Ion Implantations",
IEEE Electron Device Letters (1986), EDL-7, No.1, pp. 32-34

c) S. Yamahata, Y. Matsuoka, and T. Ishibashi:
"High $f_{max}$ Collector-up AlGaAs/GaAs Heterojunction Bipolar Transistors with a Heavily Carbon-Doped Base Fabricated by Oxygen-Ion Implantation", Proceedings of the Device Research Conference (1992), pp. A2

d) T. Hirose, A. Ryoji, and M. Inada:
"A Small Collector-Up AlGaAs/GaAs Heterojunction Bipolar Transistor Fabricated Using H[+] Implantation" Japanese Journal of Applied Physics (1991), Vol. 30, No. 10A, pp. L1787-L1789

e) S. Yamahata, K. Kurishima, T. Kobayashi, and Y. Matsuoka
"InP/InGaAs Collector-up Heterojunction Bipolar Transistors Fabricated Using Fe-Ion Implantation" Proceedings of the International Conference on Indium Phosphide and Related Materials, Hokkaido, May 9-13, (1995), pp.

652-655

f) EP 0 214 802 A2

In dem Verfahren in Ref. a erfolgt für einen E-up/C-down HBT eine Reduzierung von $C_{BC}$ mittels einer tiefen Sauerstoffimplantation im extrinsischen Basis-Kollektor-Bereich unterhalb der p-leitenden Basisschicht.
In dem Verfahren von Ref. b) wird für einen C-up/E-down HBT eine isolierende, extrinsische Basis-Emitter-Zone durch eine tiefe Implantation mit Sauerstoffionen durch die p-leitende Basisschicht erzeugt.

Nachteilig bei beiden Verfahren sind jedoch die dadurch erzeugten Kristalldefekte in der Basiszone, die zu einer deutlichen Verschlechterung von $R_B$ führen und nach der Beziehung (1) sich somit nachteilig auf das Hochfrequenzverhalten auswirken. Aus diesem Grund wurde in beiden Arbeiten zusätzlich eine flache p-leitende Implantation mit Berylliumionen in die Basisschicht durchgeführt, um diesen Effekt teilweise zu kompensieren. Jedoch ist für eine hohe Trägeraktivierung im implantierten p-Basisbereich eine thermische Behandlung der Halbleiterscheibe notwendig.

In Referenz a) wurde dafür eine sehr hohe Ausheiltemperatur von 850°C vorgeschlagen. Es ist bekannt, daß derart hohe Ausheiltemperaturen für die Trägeraktivierung notwendig sind, aber andererseits ist ebenfalls bekannt, daß bei den hohen Temperaturen eine deutliche Degradation der vertikalen Schichtenfolge stattfindet. Dabei tritt insbesondere eine Diffusion der Berylliumdotieratome ein, z.B. von der Basisschicht in die Emitterschicht. Ebenso kommt es zu einer Interdiffusion der Wirtskristallatome an den Grenzflächen der Heterostrukturen. Beide Effekte wirken sich sehr nachteilig auf das Verhalten des Bauelements aus.

In Referenz b) wurde eine niedrige Ausheiltemperatur von nur 400°C für die Aktivierung der implantierten Berylliumionen vorgeschlagen. Es ist bekannt, daß bei diesen niedrigen Temperaturen keine signifikante Trägeraktivierung erreicht wird. Somit ist mit dem genannten Verfahren der Isolationsimplantation durch die Basisschicht hindurch eine sehr nachteilige Erhöhung von $R_B$ in der Basiszone zu erwarten.

In Referenz c) wurde ebenfalls mit Sauerstoffionen eine Isolation des extrinsischen Basis-Emitterbereichs durchgeführt und die nachteilige Verschlechterung in $R_B$ durch eine Zink-Diffusion kompensiert. Dadurch konnten $f_{max}$ - Werte von über 100 GHz demonstriert werden. Das Element Zink diffundiert in den Basisbereich ein und erniedrigt damit den Schichtwiderstand. Allerdings ist wegen seines hohen Diffusionskoeffizienten das Element Zink in einer Produktionsumgebung allgemein nicht akzeptiert. Das mit Zink behandelte Bauelement hat eine hohe Neigung zu vorzeitiger Degradation, insbesondere im Hochstrombetrieb und/oder unter thermischer Belastung, wo es zu einer unkontrollierten Zinkdiffusion im Halbleiter kommen kann. Dadurch treten parasitäre Leckströme im extrinsischen Bereich oder Degradation am pn-Übergang im intrinsischen Bauelement auf.

In Referenz d) wurde die Isolation unterhalb der extrinsischen Basisgebiete mit Hilfe einer Wasserstoff ($H^+$) Implantation realisiert. Dadurch wird eine Erniedrigung von $C_{BC}$ erreicht, jedoch nimmt $R_B$ durch die Kristallschädigung in der Basisschicht überproportional zu. Außerdem ist die durch Kristalldefekte erzeugte Isolationswirkung von Protonen in Galliumarsenid thermisch nicht besonders stabil. Somit kann $R_B$ auch nicht durch eine nachträgliche Dotierimplantation mit anschließender Hochtemperaturausheilung erniedrigt werden.

In Referenz e) wird ein InP/InGaAs Heterobipolartransistor mit einer C-up/E-down Anordnung beschrieben. Ebenso wie in den o.a. Referenzen ist auch hier die Isolation des extrinsischen Basis-Emitterbereichs, die mittels Fe-Ionenimplantation erzielt wird. Das Verfahren zur Herstellung der gesamten Schichtstruktur des Transistors beinhaltet eine zweistufiges Wachsen der Halbleiterschichten, indem nach Herstellung des Emitters und der extrinsischen Isolation in einem weiteren Wachstumsprozeß die Halbleiterschichten der Basis und des Kollektors erzeugt werden.

In Referenz f) wird ein Verfahren zur Herstellung eines Bipolartransistors angegeben, bei dem in einem Teilschritt der Prozeßkette eine Schutzschicht zur Strukturierung einer Kollektorschicht temporär verwendet und im weiteren Verlauf des Verfahrens wieder abgetragen wird, um an deren Stelle auf der Kollektorschicht weitere epitaktische Schichtenfolgen für die Basis und Emitterdefinition abzuscheiden.

Der Erfindung liegt die Aufgabe zugrunde, ein Verfahren für einen C-up/E-down HBT anzugeben, mit dem ein HBT mit einem hohen $f_{max}$ hergestellt wird, dadurch, daß sowohl $C_{BC}$ wesentlich erniedrigt wird und keine herstellungsbedingte Degradation des Basisbahnwiderstands eintritt.

Die Aufgabe wird gelöst durch die in Anspruch 1 angegebenen Merkmale. Vorteilhafte Ausgestaltungen und Weiterbildungen sind den Unteransprüchen zu entnehmen. Das Herstellungsverfahren beruht auf einer Kombination von selektiver Implantation mit z.B. Sauerstoffionen zur Isolation der extrinsischen Basis-Emitter-Bereiche und einer epitaktischen Überwachstumstechnik zur Abscheidung der Basis- und Kollektorschichten. Das Verfahren ist anwendbar auf HBT-Strukturen mit GaAs/AlGaAs-Heterostrukturen und GaAs/GaInP-Heterostrukturen oder einer vorteilhaften Kombination aus beiden Heterostrukturen. Für das epitaktische Überwachsen sind vorteilhafterweise Feststoffquellen-Molekularstrahlepitaxie (MBE) oder Gasphasenepitaxie (z.B. MOCVD) zu verwenden, wobei vor dem Überwachsen eine Reinigung der Halbleiteroberfläche durch eine matierialselektive in-situ thermische Desorption oder durch ein materialselektives in-situ Ätzen einer GaAs-Schutzschicht erfolgt.

Die erfindungsgemäße Lösung wird anhand eines Ausführungsbeispiels anhand von schematischen Zeichnungen beschrieben.

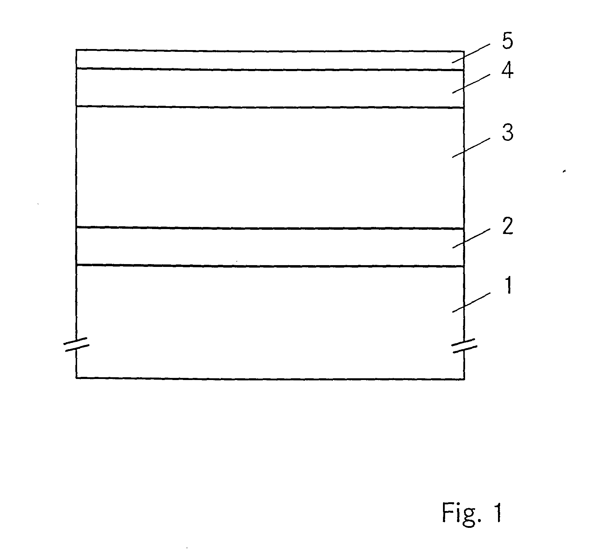

In Fig. 1 ist der erste Teil des Halbleiterschichtaufbaus für die vorgeschlagene Bauelementanordnung dargestellt. Als Substrat wird eine halbisolierende GaAs-Scheibe verwendet. Mit Hilfe einer Epitaxiemethode, vorzugsweise MBE oder MOCVD wird eine Pufferschicht 2 aus undotiertem GaAs-Material und AlGaAs/GaAs-Übergitter hergestellt. Danach wird die Halbleiterschichtenfolge für den Emitterbereich des HBT abgeschieden.

Eine Schichtenfolge für eine mit MBE hergestellte GaAs/AlGaAs-HBT Struktur mit Beryllium -dotierter Basis besteht z.B. aus:

| Schicht | Dicke(nm) | Dotierkonzentration | Materialzusammensetzung |
|---------|-----------|---------------------|-------------------------|
| 3 | 800 | $5 \times 10^{18}$ cm$^{-3}$ (n) | GaAs |
| 4 | 80 | $2 \times 10^{17}$ cm$^{-3}$ (n) | Al(x)Ga(1-x)As von x= 0 bis x= 0,3 kontinuierlich ansteigend |
| 5 | 40 | undotiert | GaAs |

Die dünne undotierte GaAs-Schicht 5 ist als Schutzschicht vorgesehen, die vor dem epitaktischen Überwachstumsprozeß durch in-situ thermische Desorption oder in-situ selektives Ätzen entfernt wird. Dabei stoppt dieser Reinigungsschritt an der Oberfläche der Emitterschicht 4. Die Schicht 4 hat die Funktion als Emitterschicht für das HBT-Bauelement und die Funktion einer Desorptionsstoppschicht bzw. Ätzstoppschicht für das Herstellungsverfahren. Dadurch wird eine kontaminationsfreie Oberfläche für den epitaktischen Überwachstumsprozeß realisiert.

Zusätzlich kann zwischen Schicht 4 und Schicht 5 eine dünne AlAs-Schicht eingebaut werden werden, z.B. mit 2-3 nm, die als zusätzliche Löcherbarriere und Desorptionsstopp- bzw. Ätzstoppschicht wirkt.

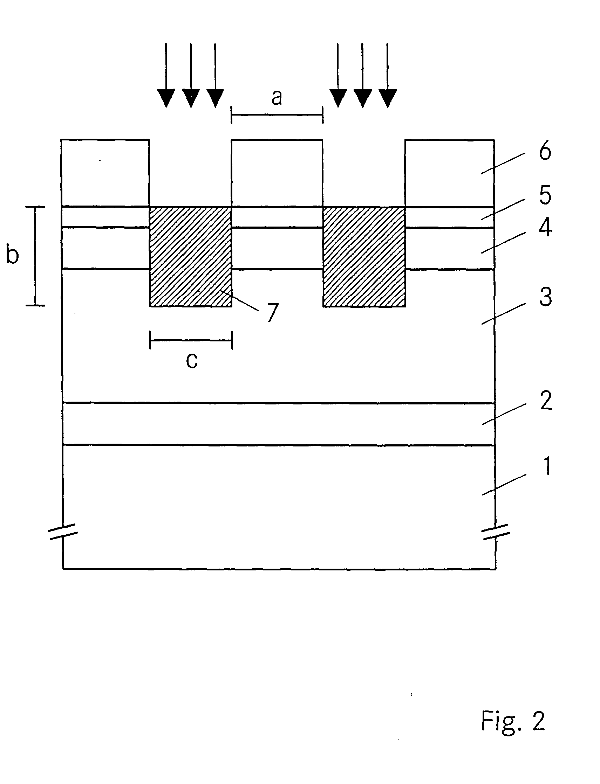

Die Halbleiterscheibe wird, wie in Fig. 2 dargestellt, in einem weiteren ex-situ Implantationsprozeß mit einer Schicht, vorzugsweise einer dielektrischen Schicht 6 aus z.B. $SiO_2$ oder SiON, versehen und mit einem photolithographischen Verfahren werden Fenster geöffnet, deren laterale Position und Geometrie die extrinsischen Basis-Emitter-Bereiche definieren und deren Abstand (a) den effektiven, stromführenden Kanal des intrinsischen Bauelements definieren. Die hergestellte Maske dient als Implantationsmaske für eine selektive Implantation mit Sauerstoffionen zur Realisierung der isolierenden, extrinsischen Basis-Emitter-Bereiche.

Die Implantation erfolgt beispielsweise mit einer Ionendosis von $6 \times 10^{14}$cm$^{-2}$ und einer Ionenenergie von 160 keV. Damit ergibt sich eine Isolationstiefe (b) des isolierten Bereichs (7) von ca. 200 nm. Die Implantationsdosen können zwischen 1014 und 1015 cm$^{-2}$ liegen und die Ionenenergien zwischen 100 bis 200 keV.

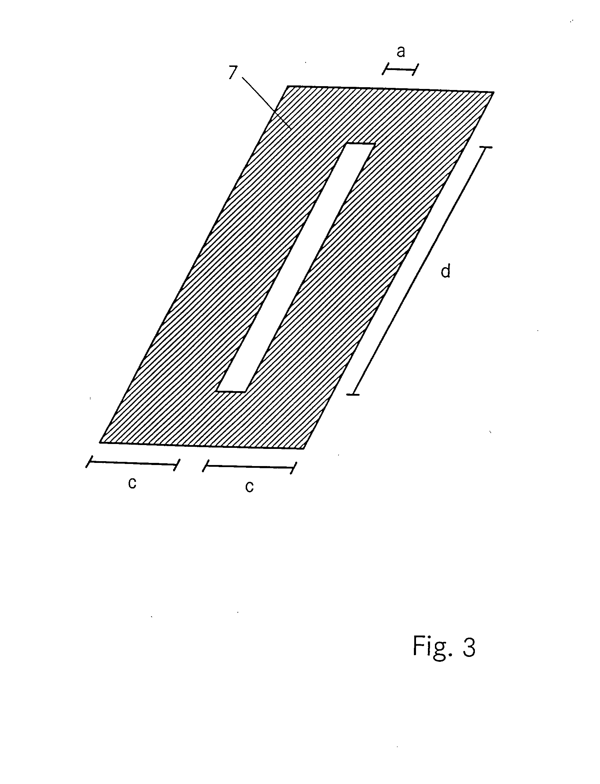

In Fig. 3 ist eine Draufsicht des implantierten Bereichs 7 dargestellt. Die Abmessungen (a) und (d) definieren den stromführenden Kanal im HBT-Bauelement. (c) definiert die Breite der Isolationsbereiche, welche zwischen 2 $\mu$m und 3 Am liegen.

In einem weiteren in-situ Prozeßschritt wird die Halbleiterscheibe innerhalb der Epitaxieanlage zuerst auf eine Substrattemperatur von über 700°C hochgefahren, um in einem Ausheilprozeß unter Arsendruck die Sauerstoffionen zu aktivieren und die durch den Implantationsprozeß verursachte Kristallschädigung auszuheilen. Dabei kann gleichzeitig die GaAs-Schutzschicht 5 thermisch desorbiert werden, um dadurch eine mikroskopisch glatte und saubere Oberfläche der Schicht 4 für den zweiten epitaktischen Überwachstumsprozeß herzustellen. Die gewählte Substrattemperatur liegt unterhalb der Oberflächendegradationstemperatur.

Alternativ zur thermischen Desorption von Schicht 5 kann durch ein in-situ Ätzverfahren die Schicht 5 materialselektiv abgetragen werden, z.B. mit $AsBr_3$ oder $AsCl_3$. Das in-situ Ätzen hat den Vorteil, daß die Scheibe nur auf die Epitaxietemperatur hochgefahren werden muß und alternativ zum chemisch-induzierten Isolationsverhalten der Sauerstoffionen die schädigungsinduzierte Isolationswirkung ausgenutzt werden kann.

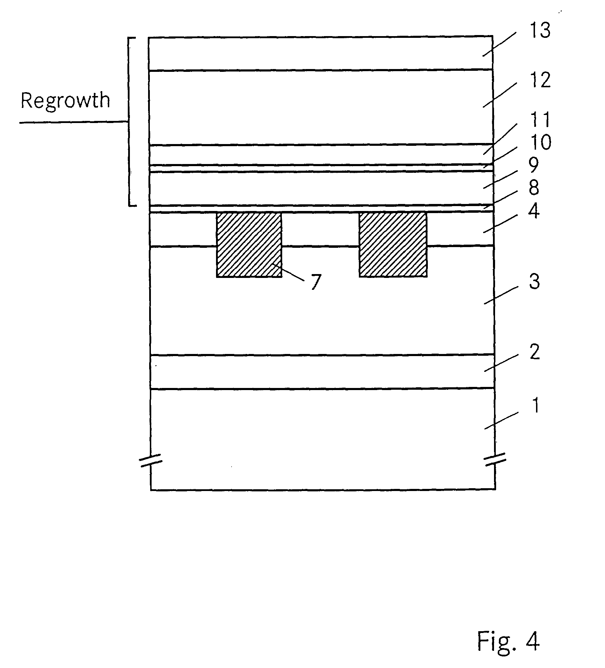

Nach dem in-situ Reinigungsschritt erfolgt die Abscheidung der Basis- und Kollektorschichtenfolgen des HBT mit Hilfe eines epitaktischen Überwachstumsprozeß (Regrowth). Dies ist in Fig. 4 schematisch dargestellt:

| Schicht | Dicke(nm) | Dotierkonzentration | Materialzusammensetzung |
|---------|-----------|---------------------|-------------------------|
| 8 | 5 | undotiert | GaAs |
| 9 | 80 | $3 \times 10^{19}$cm$^{-3}$ (p) | GaAs |
| 10 | 10 | undotiert | GaAs |
| 11 | 10 | $5 \times 10^{16}$cm$^{-3}$ (n) | Ga(0,5)In(0,5)P |
| 12 | 300 | $5 \times 10^{16}$cm$^{-3}$ (n) | GaAs |
| 13 | 100 | $5 \times 10^{18}$cm$^{-3}$ (n) | GaAs |

Die Schicht 9 definiert die Basiszone und die Schichten 8 und 10 sind Spacerschichten. Die Schichten 12 und 13 definieren den Kollektor des Bauelements. Die Schicht 11 dient als Ätzstopschicht und erleichtert das selektive Freilegen der Basisschicht für das Aufbringen der Kontaktmetallisierung.

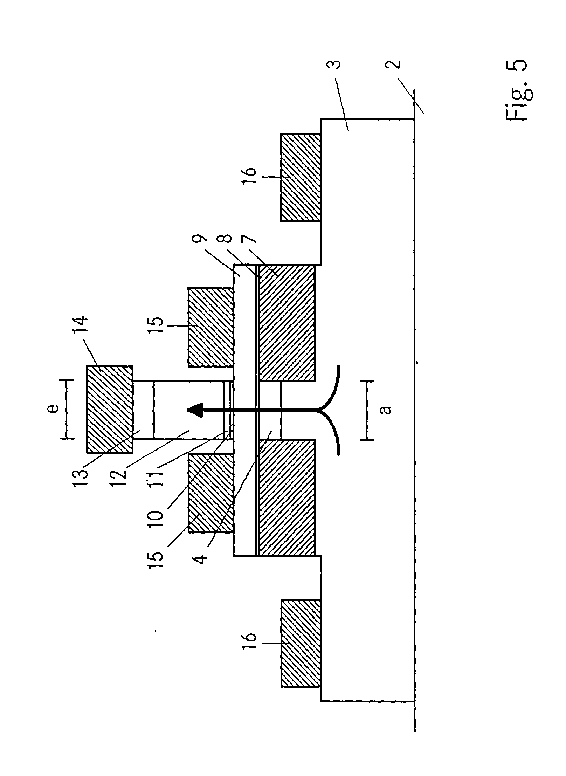

Für die Bauelementherstellung wird zunächst der Kollektorkontakt 14 mit photolithographischen Verfahren hergestellt, wie in Fig. 5 schematisch dargestellt. Danach erfolgt eine Mesaätzung mit naßchemischen oder trockenchemischen Verfahren. Der Grad der Unterätzung und die Kontaktbreite definieren die effektive Breite (e) des stromführenden Kollektorbereichs. Anschließend wird die Ätzstoppschicht 11 und die Spacerschicht 10 selektiv entfernt und der Basiskontakt 15, vorteilhafterweise in einem allgemein bekannten selbstjustierenden Verfahren, realisiert. Abschließend erfolgt die zweite Mesaätzung zur Definition des Emitterkontakts 16, der auf der hochleitenden Schicht 3 positioniert wird, derart, daß die Mesaätzung in etwa mindestens so tief reicht wie das Implantationsprofil der Sauerstoffionen.

Die Kontaktmetallisierungen werden durch Einsatz von photolithographischen Verfahren und konventionellen Aufdampftechniken hergestellt. Dabei können die ohmschen Kontakte 14,16 für die n-leitenden Kontaktbereiche des Bauelements mit einer beispielhaften Metallisierungsschichtenfolge Ge/Ni/Au und die p-leitenden Kontakte 15 mit einer beispielhaften Metallisierungsschichtenfolge Ti/Pt/Au realsiert werden. Durch einen Kurzzeitausheilschritt, beispielsweise bei ca. 400°C, erfolgt die Legierung sämtlicher ohmscher Kontakte des Bauelements.

Vorteilhafte Kollektorkontaktgeometrien sind allgemein bekannte Fingeranordnungen mit Fingerbreiten im Bereich zwischen 0,5 µm und 2 µm und Fingerlängen im Bereich zwischen 5 Am und 20 µm. Die Basiskontakte sind vorteilhafterweise selbstjustierend als U-förmige Metallisierung um den Kollektorkontakt angeordnet. Der Abstand (a) zwischen den Implantationsbereichen ist vorteilhafterweise mittig und zentrisch zum Kollektor auszurichten und so zu wählen, daß (a) mit der Kollektorbreite (e) übereinstimmt oder etwas kleiner ist.

Alternativ zum ersten Ausführungsbeispiel kann eine beispielhafte Schichtenfolge für eine mit MOCVD hergestellte GaAs/GaInP-HBT Struktur mit Kohlenstoff-dotierter Basis hergestellt werden, wobei die Schichten 4 und 9 zu ersetzen sind durch:

| Schicht | Dicke(nm) | Dotierkonzentration | Materialzusammensetzung |
|---------|-----------|---------------------|-------------------------|
| 4 | 20 | $2 \times 10^{17} \text{cm}^{-3}$ (n) | Ga(0,5)In(0,5)P |
| 9 | 60 | $8 \times 10^{19} \text{cm}^{-3}$ (p) | GaAs |

Mit MOCVD kann außerdem auch alternativ oder zusätzlich zu den o.g. Reinigungstechniken eine in-situ Ätzung mit z.B. einem Chlorgasprozeß vor dem epitaktischen Überwachsen durchgeführt werden.

Die Erfindung ist nicht auf die angegebenen Ausführungsbeispiele beschränkt, sondern es können sämtliche Kombinationen aus AlGaAs und GaInP, sowie mit Beryllium und Kohlenstoffdotierung in der Basis realisiert werden. Die Dotierung zur Erzeugung der n-leitenden Bereiche erfolgt vorteilhafterweise mit Silizium.

Weiterhin kann nach dem ex-situ Implantationsprozeß in einem weiteren Schritt die Halbleiterscheibe mit einer dielektrischen Schicht versehen werden, beispielsweise SiON oder $SiO_2$, und ein ex-situ Kurzzeitausheilschritt bei einer hohen Temperatur zwischen 700°C und 800°C durchgeführt werden, um die durch den Implantationsprozeß verursachten Kristalldefekte auszuheilen und die Sauerstoffionen zu aktivieren.

Der HBT ist nicht auf die in den Ausführungsbeispielen angegebene Mesa-Struktur beschränkt, sondern mit dem erfindungsgemäßen Verfahren können auch planare Strukturen mit entsprechenden Kontaktzonen hergestellt werden.

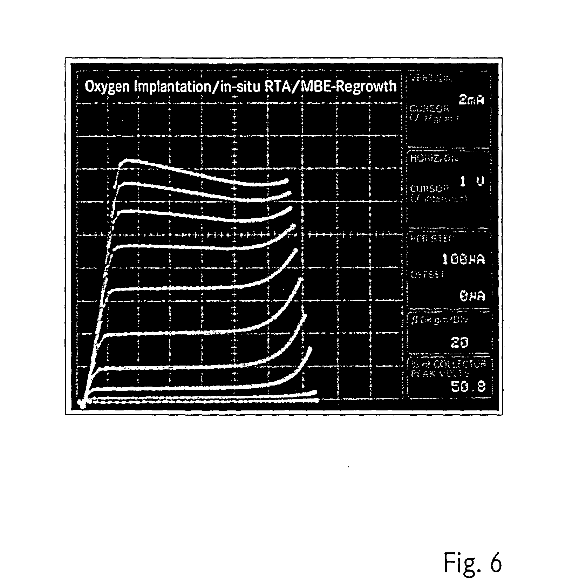

In Fig. 6 ist das Ausgangskennlinienfeld des Emitter-Kollektor-Stroms als Funktion der angelegten Emitter-Kollektor-Spannung bei unterschiedlichen Basis-Emitter-Strömen einer beispielhaften C-up/E-down HBT-Anordnung nach Ausführungsbeispiel I dargestellt.

**Patentansprüche**

**1.** Verfahren zur Herstellung eines Heterobipolartransistors mit obenliegendem Kollektorbereich und darunterliegendem Basis- und Emitterbereich, wobei

- im ersten Verfahrensschritt der Emitterbereich hergestellt wird,
- im zweiten Verfahrensschritt mittels eines epitaktischen Überwachstumsprozeß die Basis und der Kollektor hergestellt werden,
- die ohmschen Kontakte (14, 15, 16) in Verbindung mit einer Mesastrukturierung hergestellt werden,

wobei im ersten Verfahrensschritt

- die den Emitterbereich bildenden Halbleiterschichten (3, 4) aus einer n-dotierten GaAs-Schicht (3) und einer n-dotierten AlGaAs- oder n-dotierten GaInP-Schicht (4) epitaktisch auf eine auf ein Substrat aufgebrachte Pufferschicht (2) gewachsen werden,

- auf die den Emitter bildenden Halbleiterschichten eine Schutzschicht (5) aus GaAs aufgewachsen wird
- anschließend eine den Emitterbereich umgebende und diesen definierende isolierende Zone (7) selektiv durch eine Maske implantiert wird und dann ein Ausheilprozeß durchgeführt wird,

und im zweiten Verfahrensschritt

- die Schutzschicht durch thermische Desorption oder durch selektives Ätzen entfernt wird und die Halbleiterschicht (4) freigelegt wird,
- für die Basis eine Schichtenfolge aus einer undotierten GaAs-Schicht (8) als Spacer, einer p-dotierten Basisschicht (9) aus GaAs, einer undotierten GaAs-Schicht (10) als Spacer,
- für den Kollektor eine Schichtenfolge aus einer n-dotierten GaInP-Schicht (11) und zwei unterschiedlich n-dotierten Kollektorschichten (12, 13) aus GaAs abgeschieden werden.

2. Verfahren nach Anspruch 1, dadurch gekennzeichnet,

- daß die isolierenden Zonen (7) mit Sauerstoffionen erzeugt werden, und
- daß die Implantationsdosis zwischen $10^{14}$cm$^{-2}$ und $10^{15}$cm$^{-2}$ beträgt, bei einer Ionenenergie von 100 bis 200 keV.

3. Verfahren nach Anspruch 2, dadurch gekennzeichnet, daß der Ausheilprozeß in-situ bei ca. 700°C durchgeführt wird und unter Arsengasdruck die Sauerstoffionen aktiviert werden.

4. Verfahren nach Anspruch 1 und 2, dadurch gekennzeichnet, daß der Ausheilprozeß ex-situ und für eine kurze Zeitspanne bei einer Temperatur zwischen 700°C und 800°C durchgeführt wird, derart, daß vor dem Ausheilschritt die Halbleiteroberfläche mit einer dielektrischen Schicht abgedeckt wird.

5. Verfahren nach Anspruch 1 oder 2, dadurch gekennzeichnet, daß die GaInP-Schicht (11) und die AlGaAs-Schicht (4) als Ätzstoppschichten bei der Bauelementstrukturierung eingesetzt werden.

## Claims

1. Method for fabricating a heterojunction bipolar transistor having an overlying collector region and underlying base and emitter region, in which case

- in the first method step, the emitter region is fabricated;
- in the second method step, the base and the collector are fabricated by means of an epitaxial regrowth process,
- the ohmic contacts (14, 15, 16) are fabricated in conjunction with mesa patterning, in which case, in the first method step,
- the semiconductor layers (3, 4) which form the emitter region and comprise an n-doped GaAs layer (3) and an n-doped AlGaAs or n-doped GaInP layer (4) are grown epitaxially on a buffer layer (2) applied to a substrate,
- a protective layer (5) made of GaAs is grown on the semiconductor layers which form the emitter,
- afterwards an insulating zone (7) which surrounds the emitter region and defines the latter is implanted selectively through a mask and an annealing process is then carried out, and, in the second method step,
- the protective layer is removed by thermal desorption or by selective etching and the semiconductor layer (4) is uncovered,
- for the base, a layer sequence comprising an undoped GaAs layer (8) as spacer, a p-doped base layer (9) made of GaAs, and an undoped GaAs layer (10) as spacer are deposited,
  for the collector, a layer sequence comprising an n-doped GaInP layer (11) and two differently n-doped collector layers (12, 13) made of GaAs are deposited.

2. Method according to Claim 1, characterized in that the insulating zones (7) are produced using oxygen ions, and

- in that the implantation dose is between $10^{14}$ cm$^{-2}$ and $10^{15}$ cm$^{-2}$, with an ion energy of from 100 to 200 keV.

3. Method according to Claim 2, characterized in that the annealing process is carried out in situ at approximately 700°C and the oxygen ions are activated under arsenic gas pressure.

4. Method according to Claims 1 and 2, characterized in that the annealing process is carried out ex situ and for a short period of time at a temperature of between 700°C and 800°C, in such a way that the semiconductor surface is covered with a dielectric layer before the annealing step.

5. Method according to Claim 1 or 2, characterized in that the GaInP layer (11) and the AlGaAs layer (4) are used as etching stop layers during the component patterning.

**Revendications**

1. Procédé de fabrication d'un transistor hétérobipolaire avec zone de collecteur sur le dessus et zone de base et d'émetteur sous celle-ci,

   - la zone d'émetteur étant fabriquée au cours de la première étape du procédé,
   - la base et le collecteur étant fabriqués au cours de la deuxième phase du procédé au moyen d'un processus de surcroissance épitaxial,
   - les contacts ohmiques (14, 15, 16) étant fabriqués en liaison avec une structure de type mesa, avec lequel, au cours de la première étape du procédé,
   - les couches de semiconducteur (3, 4) formant la zone d'émetteur et composées d'une couche de GaAs dopée n (3) et d'une couche d'AlGaAs dopée n ou d'une couche de GaInP dopée n (4) sont amenées à croître de manière épitaxiale sur une couche tampon (2) appliquée sur un substrat,
   - une couche de protection (5) en GaAs amenée à croître sur les couches de semiconducteur formant l'émetteur,
   - une zone (7) entourant l'émetteur et l'isolant de manière définie est ensuite implantée de manière sélective à l'aide d'un masque, ce qui est suivi d'un processus de cicatrisation, et, au cours de la deuxième étape du procédé,
   - la couche de protection est retirée par désorption thermique ou par corrosion sélective et la couche de semiconducteur (4) est libérée,
   - une série de couches composée d'une couche de GaAs non dopé (8) faisant office d'écarteur, une couche de base dopée p (9) en GaAs, une couche de GaAs non dopé (10) faisant office d'écarteur sont déposées pour la base,
   - une série de couches composée d'une couche de GaInP dopé n (11) et de deux couches de collecteur différentes dopées n (12, 13) en GaAs sont déposées pour le collecteur.

2. Procédé selon la revendication 1, caractérisé en ce

   - que les zones isolantes (7) sont produites avec des ions d'oxygène, et
   - que la dose d'implantation est comprise entre $10^{14}$cm$^{-2}$ et $10^{15}$cm$^{-2}$ avec une énergie ionique de 100 à 200 keV.

3. Procédé selon la revendication 2, caractérisé en ce que le processus de cicatrisation est effectué in-situ à environ 700°C et les ions d'oxygènes sont activés sous de l'arsenic gazeux sous pression.

4. Procédé selon la revendication 1 et 2, caractérisé en ce que le processus de cicatrisation est effectué ex-situ et pendant une courte période à une température d'environ 700°C à 800°C de manière à ce que la surface en semiconducteur soit recouverte d'une couche diélectrique avant l'étape de cicatrisation.

5. Procédé selon la revendication 1 ou 2, caractérisé en ce que la couche de GaInP (11) et la couche d'AlGaAs (4) sont utilisées comme couches stoppant la corrosion lors de la création de la structure du composant.

Fig. 1

Fig. 2

Fig. 3

Fig. 4

Fig. 5

Fig. 6